(19) **Europäisches Patentamt / European Patent Office / Office européen des brevets**

(11) **EP 4 778 775 A2**

(12) # EUROPEAN PATENT APPLICATION

(43) Date of publication:
**22.07.2026  Bulletin 2026/30**

(21) Application number: **26176496.3**

(22) Date of filing: **15.09.2023**

(51) International Patent Classification (IPC):
**B60L 58/21** *(2019.01)*

(52) Cooperative Patent Classification (CPC):
**G01R 31/3835; B60L 3/0046; B60L 3/0069;
B60L 3/12; B60L 58/12; B60L 58/21;**
B60L 2240/547; B60L 2240/80; G01R 19/12;
G01R 19/16542; G01R 31/371; G01R 31/396;
Y02E 60/10

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **16.09.2022  KR 20220117335**

(62) Document number(s) of the earlier application(s) in
accordance with Art. 76 EPC:
**23865918.9 / 4 545 991**

(71) Applicant: **LG Energy Solution, Ltd.
Seoul 07335 (KR)**

(72) Inventor: **YEOM, In-Cheol
34122 DAEJEON (KR)**

(74) Representative: **Plasseraud IP
104 Rue de Richelieu
CS92104
75080 Paris Cedex 02 (FR)**

Remarks:
•This application was filed on 05.05.2026 as a
divisional application to the application mentioned
under INID code 62.
•Claims filed after the date of filing of the application /
after the date of receipt of the divisional application
(Rule 68(4) EPC).

(54) **BATTERY DIAGNOSIS APPARATUS, BATTERY DIAGNOSIS METHOD, BATTERY PACK, AND VEHICLE**

(57)    Disclosed is a battery diagnosis apparatus, which includes a voltage sensing circuit configured to generate a voltage signal indicating a cell voltage of a battery cell; a storage medium configured to store time series data for the cell voltage; and a control circuit operably coupled with the voltage sensing circuit and the storage medium. The control circuit is configured to (i) receive the voltage signal and record the time series data for the cell voltage in the storage medium, (ii) determine a first cell voltage slope in a first time section and a second cell voltage slope in a second time section different from the first time section based on the time series data, (iii) determine an average slope of the cell voltage in a third time section between the first time section and the second time section based on the time series data, and (iv) set the first cell voltage slope and the second cell voltage slope as boundary conditions of a normal slope range, and diagnose a voltage abnormality in response to the average slope of the cell voltage being outside the normal slope range.

EP 4 778 775 A2

**Description**

TECHNICAL FIELD

The present disclosure relates to a technology for diagnosing a voltage abnormality of a battery.
The present application claims priority to Korean Patent Application No. 10-2022-0117335 filed on September 16, 2022 in the Republic of Korea, the disclosure of which is incorporated herein by reference in its entirety.

BACKGROUND ART

Recently, there has been a rapid increase in the demand for portable electronic products such as laptop computers, video cameras and mobile phones, and with the extensive development of electric vehicles, energy storage systems, robots and satellites, many studies are being made on high performance batteries that can be recharged repeatedly.
Currently, commercially available batteries include nickel-cadmium batteries, nickel-hydrogen batteries, nickel-zinc batteries, lithium ion batteries and the like. Among them, lithium batteries have little or no memory effect, and thus they are gaining more attention than nickel-based batteries for their advantages that recharging can be done whenever it is convenient, the self-discharge rate is very low and the energy density is high.
Recently, as applications requiring high voltage (e.g., energy storage systems, electric vehicles) become widespread, the need for diagnostic technology that accurately detects voltage abnormalities in each of the plurality of battery cells connected in series within a battery pack is increasing.
The voltage abnormality of a battery cell refers to a fault condition in which the cell voltage drops and/or rises abnormally due to internal short-circuit, external short-circuit, failure of the voltage sensing line, or poor connection with the charging/discharging line.
Conventionally, a simple method was used to diagnose a voltage abnormality of a battery cell by determining whether the difference between cell voltages measured at two different time points exceeds a reference value. This method has the advantage of not requiring a high-performance processor because the amount of data calculation is not large.
However, since the voltage of a battery cell also depends on temperature, current, and/or SOH (State Of Health) of the battery cell, it is not easy to accurately diagnose the voltage abnormality of the battery cell by simply comparing the difference of the voltages of the battery cell measured at different time points with the reference value.
In addition, if the voltage difference between the battery cells is lower than or equal to the reference value but the voltage slope of the battery cell shows abnormal behavior, for example, when lithium plating (Li-plating) occurs on the negative electrode of a lithium battery, there is a limit in that an abnormality in cell voltage cannot be detected.

DISCLOSURE

Technical Problem

The present disclosure is designed to solve the problems of the related art, and therefore the present disclosure is directed to providing a battery diagnosis apparatus, a battery diagnosis method, a battery pack, and a vehicle, which may efficiently and accurately diagnose a voltage abnormality of a battery cell using a voltage change slope of the battery cell.
These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery diagnosis apparatus, comprising: a voltage sensing circuit configured to generate a voltage signal indicating a cell voltage of a battery cell; a storage medium configured to store time series data for the cell voltage; and a control circuit operably coupled with the voltage sensing circuit and the storage medium.
The control circuit may be configured to: (i) receive the voltage signal and record the time series data for the cell voltage in the storage medium, (ii) determine a first cell voltage slope in a first time section and a second cell voltage slope in a second time section different from the first time section based on the time series data, (iii) determine an average slope of the cell voltage in a third time section between the first time section and the second time section based on the time series data, and (iv) set the first cell voltage slope and the second cell voltage slope as boundary conditions of a normal slope range, and diagnose a voltage abnormality in the battery cell in response to the average slope of the cell voltage being outside the normal slope range.

A time width of the third time section may be greater than a time width of the first time section and a time width of the second time section.

The time width of the first time section and the time width of the second time section may be substantially the same.

According to an embodiment, the control circuit may be configured to diagnose the voltage abnormality in response to the first cell voltage slope, the second cell voltage slope, and the average slope of the cell voltage not satisfying the following inequality, for cell voltages in the time series data to show a pattern of substantially continuously decreasing:

$$\text{first cell voltage slope} < \text{average slope of the cell voltage} < \text{second cell voltage slope.}$$

According to another embodiment, the control circuit may be configured to diagnose the voltage abnormality in response to the first cell voltage slope, the second cell voltage slope, and the average slope of the cell voltage not satisfying the following inequality, for cell voltages in the time series data to show a pattern of substantially continuously increasing:

$$\text{first cell voltage slope} > \text{average slope of the cell voltage} > \text{second cell voltage slope.}$$

According to still another embodiment, the control circuit may be configured to diagnose the voltage abnormality in response to neither of the following inequality and equation being satisfied, for a battery cell having an operation state that switches from a charge state to a no-load state:

$$\text{first cell voltage slope} < \text{average slope} < \text{second cell voltage slope}$$

$$\text{first cell voltage slope} = \text{average slope} = \text{second cell voltage slope.}$$

According to still another embodiment, the control circuit may be configured to diagnose the voltage abnormality in response to neither of the following inequality and equation being satisfied, for a battery cell having an operation state that switches from a discharge state to a no-load state:

$$\text{first cell voltage slope} > \text{average slope} > \text{second cell voltage slope}$$

$$\text{first cell voltage slope} = \text{average slope} = \text{second cell voltage slope.}$$

The control circuit may be configured to update a voltage abnormality detection count in response to diagnosis of the voltage abnormality.

The battery diagnosis apparatus may further comprise a display operably coupled with the control circuit. The control circuit may be configured to output the result of diagnosing a battery cell satisfying a condition that the voltage abnormality detection count is greater than or equal to a reference value as a battery cell exhibiting a voltage abnormality through the display.

The battery diagnosis apparatus may further comprise an interface unit operably coupled with the control circuit to support communication with an external device. The control circuit may be configured to transmit the result of diagnosing a battery cell satisfying a condition that the voltage abnormality detection count is greater than or equal to a reference value as a battery cell exhibiting a voltage abnormality to an external device through the interface unit.

In another aspect of the present disclosure, there is also provided a battery diagnosis method, comprising: a first step of receiving a voltage signal indicating a cell voltage of a battery cell from a voltage sensing circuit and recording time series data for the cell voltage in a storage medium; a second step of determining a first cell voltage slope in a first time section based on the time series data; a third step of determining a second cell voltage slope in a second time section, which is later than the first time section, based on the time series data; a fourth step of determining an average slope of the cell voltage in a third time section between the first time section and the second time section based on the time series data; a fifth step of setting the first cell voltage slope and the second cell voltage slope as boundary conditions of a normal slope range; and a sixth step of diagnosing a voltage abnormality in the battery cell in response to the average slope of the cell voltage being outside the normal slope range.

In another aspect of the present disclosure, there is also provided a battery pack comprising the battery diagnosis apparatus described above, and a vehicle comprising the battery pack.

Advantageous Effects

According to an embodiment of the present disclosure, a battery cell exhibiting a voltage abnormality may be identified through simple calculation using the slope of the cell voltage calculated in the first time section and the second time section and the average slope of the cell voltage determined between the first time section and the second time section.

According to another embodiment of the present disclosure, since the calculation method used for battery diagnosis is not complicated, a processor with high specification is not required.

According to still another embodiment of the present disclosure, a battery cell that exhibit abnormal voltage behavior may be reliably identified even if the difference between voltages measured at different time points is not large.

The effects of the present disclosure are not limited to the above-mentioned effects, and these and other effects not mentioned herein will be clearly understood by those skilled in the art from the appended claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is an exemplary diagram showing an electric vehicle according to an embodiment of the present disclosure.

FIG. 2a is a diagram showing a first time section T1, a second time section T2, and a third time section T3 according to an embodiment of the present disclosure in time series data for a cell voltage processed in a first diagnosis cycle.

FIG. 2b is a diagram showing the first time section T1, the second time section T2, and the third time section T3 according to an embodiment of the present disclosure in the time series data for a cell voltage processed in a second diagnosis cycle.

FIG. 2c is a diagram showing the first time section T1, the second time section T2, and the third time section T3 according to an embodiment of the present disclosure in the time series data for a cell voltage processed in an arbitrary $m^{th}$ diagnosis cycle.

FIG. 3a is a graph showing an example of time series data for a cell voltage of a battery cell with a normal voltage according to an embodiment of the present disclosure.

FIG. 3b is a graph showing an example of time series data for a cell voltage of a battery cell with a voltage abnormality according to an embodiment of the present disclosure.

FIG. 4a is a graph showing an example of time series data for a cell voltage of a battery cell with a normal voltage according to another embodiment of the present disclosure.

FIG. 4b is a graph showing an example of time series data for a cell voltage of a battery cell with a voltage abnormality according to another embodiment of the present disclosure.

FIG. 5 is a flowchart for illustrating a battery diagnosis method according to an embodiment of the present disclosure.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, are used to distinguish one element from another among various elements, but not intended to limit the elements by the terms.

Unless the context clearly indicates otherwise, it will be understood that the term "comprises" when used in this specification, specifies the presence of stated elements, but does not preclude the presence or addition of one or more other elements. Additionally, the term "control unit" as used herein refers to a processing unit of at least one function or operation, and may be implemented by hardware and software either alone or in combination.

In addition, throughout the specification, it will be further understood that when an element is referred to as being "connected to" another element, it can be directly connected to the other element or intervening elements may be present.

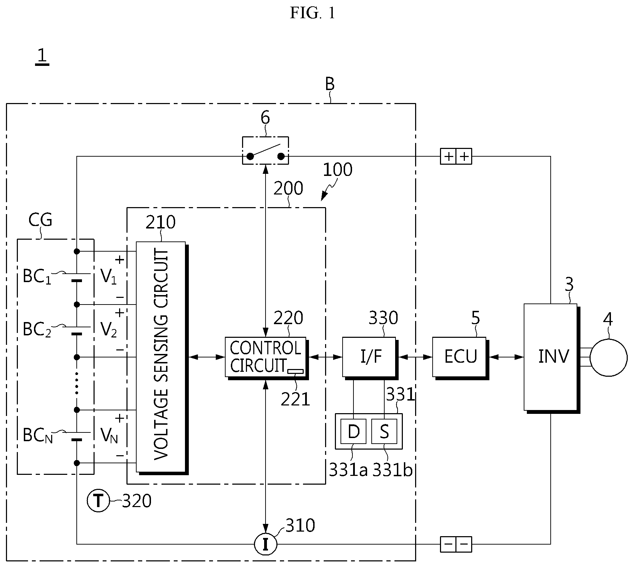

FIG. 1 is an exemplary diagram showing a vehicle according to an embodiment of the present disclosure.

Referring to FIG. 1, the vehicle 1 includes a battery pack B, an inverter 3, an electric motor 4 and a vehicle controller 5.

The vehicle 1 refers to a vehicle that can be driven by a motor using electrical energy provided by the battery pack B. As an example, the vehicle 1 may be an electric vehicle, a plug-in hybrid vehicle, or a hybrid vehicle.

The battery pack B includes a cell group CG, a switch 6, and a battery management system 100.

The cell group CG may be coupled to the inverter 3 through a pair of power terminals provided to the battery pack B. The cell group CG includes a plurality of battery cells $BC_1$ to $BC_N$ (N is a natural number of 2 or more) connected in series. The battery cell $BC_i$ is not particularly limited by its type as long as it enables repeated charging and discharging, like a lithium-ion battery cell. i is an index for battery cell identification. i is a natural number from 1 to N.

The switch 6 is connected in series to the cell group CG. The switch 6 is installed in the current path for charging and discharging the cell group CG. The switch 6 is controlled to turn on and off in response to a switching signal from the battery management system 100. The switch 6 may be a mechanical relay that turns on and off by the magnetic force of the coil, or a semiconductor switch such as a MOSFET (Metal Oxide Semiconductor Field Effect transistor).

The inverter 3 is provided to convert the direct current (DC) from the cell group CG to alternating current (AC) in response to a command from the battery management system 100 or the vehicle controller 5. The electric motor 4 may be, for example, a 3-phase AC motor. The electric motor 4 is driven using the AC power supplied from the inverter 3.

The battery management system 100 is provided to take charge of overall control related to charging and discharging of the cell group CG while the vehicle 1 is operating. Here, the operation of the vehicle 1 may include moving, parking, or waiting for a sign of the vehicle 1.

The battery management system 100 includes a battery diagnosis apparatus 200. The battery management system 100 may further include at least one of a current sensor 310, a temperature sensor 320, and an interface unit 330.

The battery diagnosis apparatus 200 is provided to diagnose voltage abnormalities in each of the plurality of battery cells $BC_1$ to $BC_N$ while the vehicle 1 is operating. The battery diagnosis apparatus 200 includes a voltage sensing circuit 210 and a control circuit 220.

The voltage sensing circuit 210 is connected to the positive electrode and negative electrode of each of the plurality of battery cells $BC_1$ to $BC_N$ through a plurality of voltage sensing lines. The voltage sensing circuit 210 is configured to measure the cell voltage across both ends of each battery cell ($BC_i$) at regular time intervals while the vehicle 1 is operating and generate a voltage signal indicating the measured cell voltage. The voltage sensing circuit 210 may include a common voltage measuring circuit known in the art. The voltage measurement circuit may include a multiplexing circuit that may sequentially select battery cells subject to voltage measurement at time intervals, a filter circuit that removes noise from the voltage measurement signal, an amplifier circuit that amplifies the voltage measurement signal, or the like.

The current sensor 310 is connected in series to the cell group CG through a current path. The current sensor 310 is configured to detect the battery current flowing through the cell group CG at regular time intervals while the vehicle 1 is operating and generate a current signal indicating the detected battery current. The current sensor 310 may be a common sensor known in the art, such as a sense resistor or a Hall sensor. The current flowing through the cell group CG may be a charging current or a discharging current.

The temperature sensor 320 is configured to detect the temperature of the cell group CG at regular time intervals while the vehicle 1 is operating and generate a temperature signal indicating the detected temperature. The temperature sensor 320 may be a common sensor known in the art, such as a thermocouple.

The control circuit 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing the other functions.

The control circuit 220 may have a storage medium 221. The storage medium 221 may be, for example, at least one type of storage medium among flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The storage medium 221 may store data and programs required for computation by the control circuit 220. The storage medium 221 may store data indicating the result of computation, for example diagnosis result, by the control circuit 220.

The control circuit 220 may be operably coupled to the voltage sensing circuit 210, the temperature sensor 320, the current sensor 310, the interface unit 330, and/or the switch 6. The control circuit 220 may collect sensing signals from the voltage sensing circuit 210, the current sensor 310, and the temperature sensor 320 at regular time intervals while the vehicle 1 is operating. The sensing signals include voltage signal, current signal, and/or temperature signal. The sensing signals may be synchronously-measured signals. The control circuit 220 may convert the voltage signal and/or current signal and/or temperature signal into digital data and accumulatively store them in the storage medium 221 to generate time series data regarding the voltage and/or current and/or temperature of the battery cell. Therefore, the time series data regarding the cell voltage of each battery cell ($BC_i$), the current flowing through the battery pack B, and the temperature of the battery pack B may be accumulatively stored in the storage medium 221.

The control circuit 220 may identify whether the battery cell is in charging, in discharging, or in a no-load state by referring to the magnitude and sign of the current measured through the current sensor 310.

Specifically, the control circuit 220 may identify that the battery cell is in a no-load state when the magnitude of the current is 0. Also, the control circuit 220 may identify that the battery cell is in discharging when the magnitude of the current is greater than 0 and the sign of the current value is positive. Also, the control circuit 220 may identify that the battery cell is in charging when the magnitude of the current is greater than 0 and the sign of the current value is negative.

The interface unit 330 may include a communication circuit configured to support wired or wireless communication between the control circuit 220 and the vehicle controller 5 (for example, an Electronic Control Unit (ECU)). The wired communication may be, for example, controller area network (CAN) communication, and the wireless communication may be, for example, Zigbee or Bluetooth communication. The communication protocol is not limited to a particular type and may include any communication protocol capable of supporting wired/wireless communication between the control circuit 220 and the vehicle controller 5.

The interface unit 330 may be coupled with an output device 331 that provides information received from the vehicle controller 5 and/or the control circuit 220 in a form recognizable to the user. The output device 331 may include a display 331a and a speaker 331b. The vehicle controller 5 may control the inverter 3 based on battery information (e.g., voltage, current, temperature, SOC) collected through communication with the battery management system 100.

The control circuit 220 may diagnose whether the battery cell exhibits a voltage abnormality using the time series data for the cell voltage of each battery cell ($BC_i$) measured by the voltage sensing circuit 210 while the vehicle 1 is operating.

Specifically, the control circuit 220 determines a first cell voltage slope in a first time section based on the time series data for the cell voltage of each battery cell ($BC_i$).

In addition, the control circuit 220 determines a second cell voltage slope in a second time section, which is later than the first time section, based on the time series data for the voltage of each battery cell ($BC_i$).

In addition, the control circuit 220 determines an average slope of the cell voltage in a third time section between the first time section and the second time section based on the time series data for the voltage of each battery cell ($BC_i$).

In addition, the control circuit 220 may be configured to set the first cell voltage slope and the second cell voltage slope as boundary conditions of a normal slope range, and diagnose that the battery cell exhibits a voltage abnormality if the condition that the average slope of the cell voltage is outside the normal slope range is established.

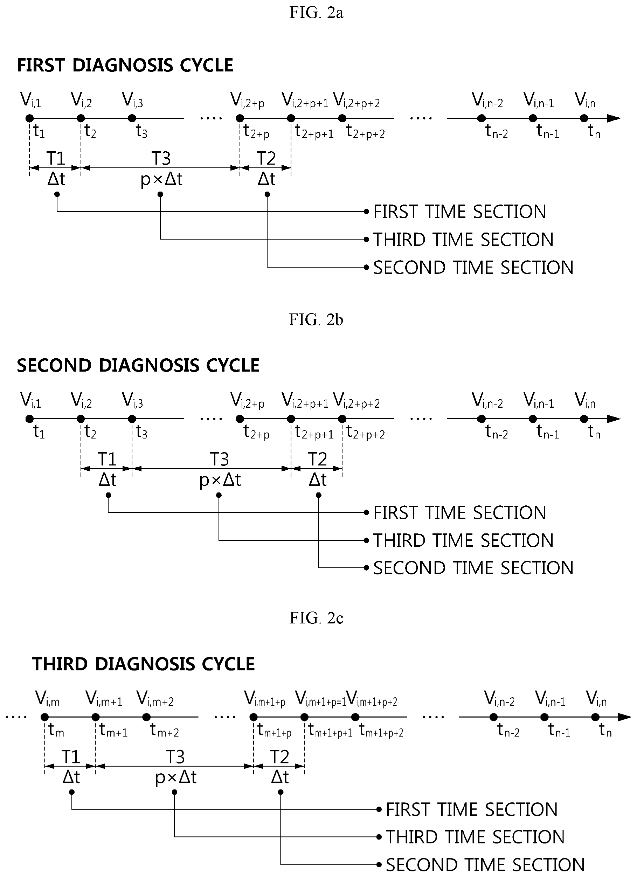

FIGS. 2a to 2c show the first time section T1, the second time section T2, and the third time section T3 according to an embodiment of the present disclosure in the time series data for the cell voltage processed in the first diagnosis cycle, the second diagnosis cycle, and the $m^{th}$ diagnosis cycle, respectively.

First, it is defined that the number of cell voltages included in the time series data for the cell voltage of the $i^{th}$ battery cell ($BC_i$) is n, the cell voltage measurement period is $\triangle t$, the length of the third time section is $p*\triangle t$, and the cell voltage measured at the $k^{th}$ measurement time point $t_k$ is $V_{i,k}$.

$\triangle t$ may be tens of msec to several seconds. p is a natural number and may be tens to thousands. Of course, the present disclosure is not limited by the sizes of $\triangle t$ and p.

Referring to FIG. 2a, in the first diagnosis cycle, the first time section is $t_1$ to $t_2$, the second time section is $t_{2+p}$ to $t_{2+p+1}$, and the third time section is $t_2$ to $t_{2+p}$.

The time width ($t_2$ to $t_{2+p}$) of the third time section is significantly greater than the time width ($t_1$ to $t_2$) of the first time section and the time width ($t_{2+p}$ to $t_{2+p+1}$) of the second time section.

In one example, when p is 1,000, the first time section may be $t_1$ to $t_2$, the second time section may be $t_{1002}$ to $t_{1003}$, and the third time section may be $t_2$ to $t_{1002}$.

In the first time section, the first cell voltage slope is $(V_{i,2} - V_{i,1})/\triangle t$.

In the second time section, the second cell voltage slope is $(V_{i,1003} - V_{i,1002})/\triangle t$.

In the third time section, the average slope of the cell voltage is $(V_{i,1002} - V_{i,2})/(1000 \times \triangle t)$.

Referring to FIG. 2b, in the second diagnosis cycle, the first time section is $t_2$ to $t_3$, the second time section is $t_{3+p}$ to $t_{3+p+1}$, and the third time section is $t_3$ to $t_{3+p}$.

In one example, when p is 1000, the first time section may be $t_2$ to $t_3$, the second time section may be $t_{1003}$ to $t_{1004}$, and the third time section may be $t_3$ to $t_{1003}$.

In the first time section, the first cell voltage slope is $(V_{i,3} - V_{i,2})/\triangle t$.

In the second time section, the second cell voltage slope is $(V_{i,1004} - V_{i,1003})/\triangle t$.

In the third time section, the average slope of the cell voltage is $(V_{i,1003} - V_{i,3})/(1000 \times \triangle t)$.

Referring to FIG. 2c, in any $m^{th}$ (m is a natural number less than or equal to 'n-p-2') diagnosis cycle, the first time

section is $t_m$ to $t_{m+1}$, the second time section is $t_{m+1+p}$ to $t_{m+1+p+1}$, and the third time section is $t_{m+1}$ to $t_{m+1+p}$.

In one example, when p is 1000, the first time section may be $t_m$ to $t_{m+1}$, the second time section may be $t_{m+1+1000}$ to $t_{m+1+1000+1}$, and the third time section may be $t_{m+1}$ to $t_{m+1+1000}$.

In the first time section, the first cell voltage slope is $(V_{i,m+1} - V_{i,m})/\triangle t$.

In the second time section, the second cell voltage slope is $(V_{i,m+1+1000+1} - V_{i,m+1+1000})/\triangle t$.

In the third time section, the average slope of the cell voltage is $(V_{i,m+1+1000} - V_{i,m+1})/(1000 \times \triangle t)$.

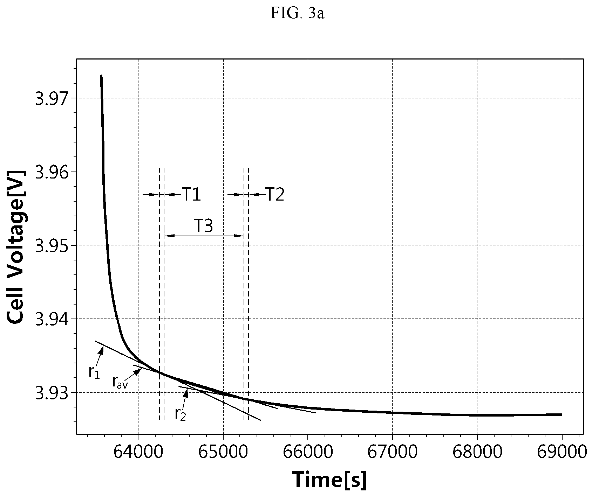

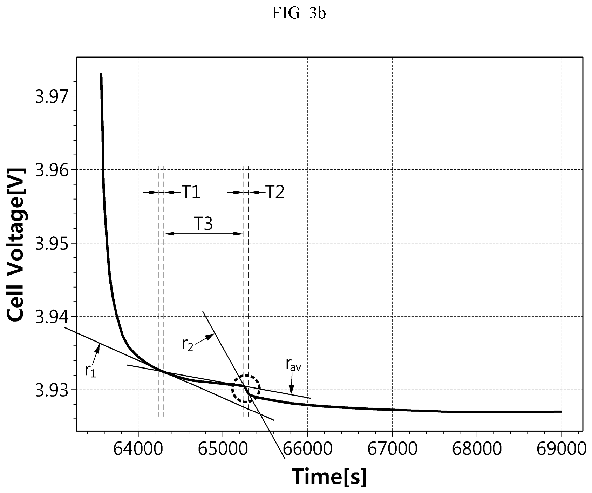

FIGS. 3a and 3b are graphs showing an example of the time series data for the cell voltage of a battery cell with a normal voltage and a battery cell with a voltage abnormality according to an embodiment of the present disclosure.

FIGS. 3a and 3b show an example of the time series data for the cell voltage when the cell voltage decreases over time. The cell voltage change in FIGS. 3a and 3b may appear when the battery cell is in discharging or when the battery cell switches from a charge state to a no-load state. The no-load state means a state where the battery cell is not charged or discharged. When the battery cell changes from the charge state to the no-load state, the IR voltage becomes 0, so the cell voltage is lowered to a stabilized voltage. At the beginning of the no-load state, the cell voltage decreases quickly, but after a certain period of time, the cell voltage gradually decreases to the stabilized voltage. The cell voltage in the stabilized state corresponds to the open circuit voltage (OCV).

Referring to FIG. 3a, the cell voltage of a battery cell with a normal voltage decreases over time without exhibiting any particular behavior in the cell voltage slope. Therefore, in the time series data section of the cell voltage where the cell voltage gradually decreases, the first cell voltage slope ($r_1$) determined in the first time section T1, the second cell voltage slope ($r_2$) determined in the second time section T2, and the average slope ($r_{av}$) of the cell voltage determined in the third time section T3 satisfy the condition of the following inequality 1. For reference, since $r_1$, $r_2$, and $r_{av}$ are negative numbers, as their absolute values are smaller, the cell voltage slope is relatively larger.

first cell voltage slope ($r_1$) < average slope ($r_{av}$) of the cell voltage < second cell voltage slope ($r_2$)　　　\<Inequality 1\>

Referring to FIG. 3b, a battery cell exhibiting a voltage abnormality shows a specific behavior in the cell voltage slope. For example, when the battery cell is a lithium-ion battery, when lithium plating occurs at the negative electrode, the cell voltage slope shows a specific behavior (see dotted circle). In other words, there appears a section where the size of the cell voltage slope gradually decreases and then increases rather. Therefore, if abnormal behavior of the cell voltage slope appears in the second time section T2, the above-mentioned condition of the inequality 1 may not be satisfied.

That is, the first cell voltage slope ($r_1$) determined in the first time section T1, the second cell voltage slope ($r_2$) determined in the second time section T2, and the average slope ($r_{av}$) of the cell voltage determined in the third time section T3 do not satisfy the inequality 1 described above, and the average slope ($r_{av}$) of the cell voltage deviates from the normal slope range defined by the first cell voltage slope ($r_1$) and the second cell voltage slope ($r_1$) and satisfies the condition of the following inequality 2.

second cell voltage slope ($r_2$) < first cell voltage slope ($r_1$) < average slope ($r_{av}$) of the cell voltage　　　\<Inequality 2\>

When the second time section T2 where the inequality 2 is satisfied is detected in any diagnosis cycle for the time series data for the cell voltage of the battery cell, the control circuit 220 records the time point at which a voltage abnormality is detected in the storage medium 221 and increases the voltage abnormality detection count by 1.

The control circuit 220 may also diagnose that the corresponding battery cell exhibits a voltage abnormality when the voltage abnormality detection count exceeds a reference value during the process of analyzing the time series data for the cell voltage according to the above-described method.

The reference value may have a value of 1 or more. The reference value may be appropriately determined considering the sensitivity of diagnosis. For example, in applications requiring high diagnostic sensitivity, the reference value may be set as 1 to 3. As another example, in applications that require a typical level of diagnostic sensitivity, the reference value may be set as 4 or higher.

The control circuit 220 may output the diagnosis result through the output device 331 when the battery cell that is a diagnosis target is diagnosed as exhibiting a voltage abnormality.

In one example, the control circuit 220 may visually output a message indicating that a battery cell with a voltage abnormality appears within the battery pack B through the display 331a connected to the interface unit 330 through a graphical user interface.

If the battery diagnosis apparatus 200 of the present disclosure is included in a battery pack B of a vehicle 1, the display 331a may be a vehicle display panel provided in the vehicle 1. In another example, when the battery diagnosis apparatus 200 of the present disclosure is included in a diagnosis system (not shown), the display 331a may be a display panel provided in the diagnosis system.

In another example, the control circuit 220 may audibly output a message indicating that the battery cell with a voltage abnormality appears within the battery pack B through the speaker 331a connected to the interface unit 330.

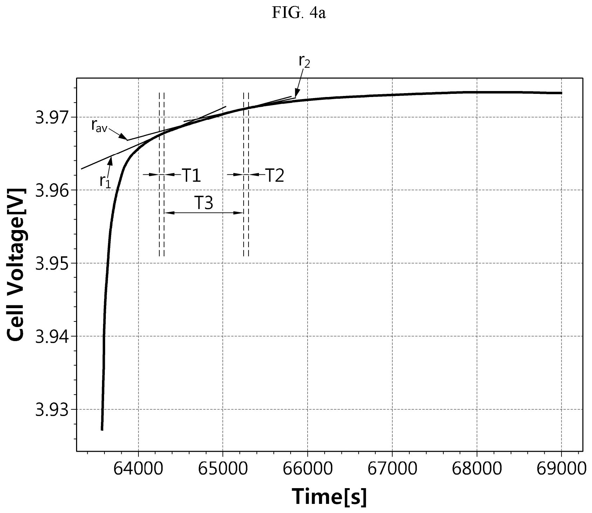

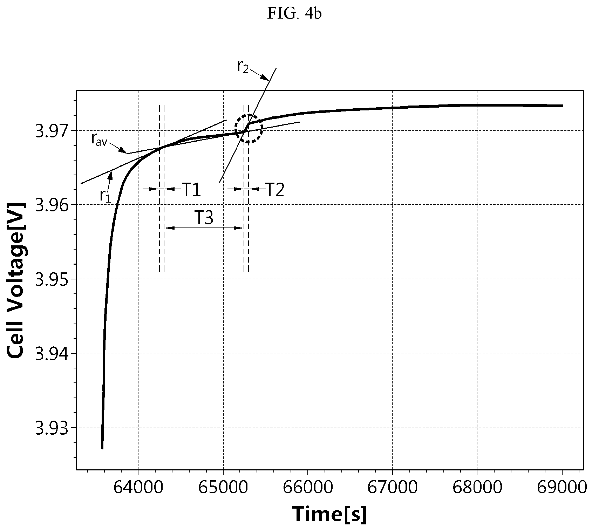

FIGS. 4a and 4b are graphs showing an example of the time series data for the cell voltage of a battery cell with normal voltage and a battery cell with a voltage abnormality according to another embodiment of the present disclosure.

FIGS. 4a and 4b show an example of the time series data for the cell voltage when the cell voltage increases over time. The cell voltage change in FIGS. 4a and 4b may appear when the battery cell is in charging or when the battery cell switches from a discharge state to a no-load state. When the battery cell changes from the discharge state to the no-load state, the IR voltage becomes 0, so the cell voltage increases to the stabilized voltage. In an initial stage where the battery cell is in the no-load state, the cell voltage increases rapidly. However, after a certain period of time, the cell voltage slowly increases to the stabilized voltage. The cell voltage in the stabilized state corresponds to the open circuit voltage (OCV).

Referring to FIG 4a, the cell voltage of a battery cell with a normal voltage increases over time without exhibiting any specific behavior in the cell voltage slope. Therefore, in the time series data section of the cell voltage where the cell voltage gradually increases, the first cell voltage slope ($r_1$) determined in the first time section T1, the second cell voltage slope ($r_2$) determined in the second time section T2, and the average slope ($r_{av}$) of the cell voltage determined in the third time section T3 satisfy the following inequality 3. For reference, since $r_1$, $r_2$, and $r_{av}$ are positive numbers, as their absolute value are larger, the cell voltage slope is relatively larger.

first cell voltage slope ($r_1$) > average slope ($r_{av}$) of the cell voltage > second cell voltage slope ($r_2$)     <Inequality 3>

Referring to FIG. 4b, a battery cell exhibiting a voltage abnormality shows a specific behavior in the cell voltage slope. For example, when the battery cell is a lithium-ion battery, if a disconnection occurs at the negative electrode tab or lithium plating occurs at the negative electrode, the voltage slope shows a specific behavior. As a result, there appears a section where the size of the cell voltage slope gradually decreases and then increases rather. Therefore, if abnormal behavior of the cell voltage slope appears in the second time section T2, the above-mentioned condition of the inequality 3 may not be satisfied.

In other words, the first cell voltage slope ($r_1$) determined in the first time section T1, the second cell voltage slope ($r_2$) determined in the second time section T2, and the average slope ($r_{av}$) of the cell voltage determined in the third time section T3 do not satisfy the inequality 3 described above, and the average slope ($r_{av}$) of the cell voltage deviates from the normal slope range defined by the first cell voltage slope ($r_1$) and the second cell voltage slope ($r_1$) and satisfies the following inequality 4.

average slope ($r_{av}$) of the cell voltage < first cell voltage slope ($r_1$) < second cell voltage slope ($r_2$)     <Inequality 4>

If the second time section T2 where the inequality 4 is satisfied is detected in any diagnosis cycle for the time series data for the cell voltage, the control circuit 220 records the time point at which a voltage abnormality is detected in the storage medium 221 and increases the voltage abnormality detection count by 1.

The control circuit 220 may also determine that the corresponding battery cell exhibits a voltage abnormality if the voltage abnormality detection count exceeds the reference value during the process of analyzing the time series data for the cell voltage according to the above-described method.

The control circuit 220 may also output the diagnosis result through the output device 331 when it is determined that the battery cell that is a diagnosis target exhibits a voltage abnormality.

In one example, the control circuit 220 may visually output a message indicating that a battery cell with a voltage abnormality appears within the battery pack B through the display 331a connected to the interface unit 330 through a graphical user interface.

If the battery diagnosis apparatus 200 of the present disclosure is included in a battery pack B of a vehicle 1, the display 331a may be a vehicle display panel provided in the vehicle 1. In another example, when the battery diagnosis apparatus 200 of the present disclosure is included in a diagnosis system (not shown), the display 331a may be a display panel provided in the diagnosis system.

In another example, the control circuit 220 may audibly output a message indicating that the battery cell with a voltage abnormality appears within the battery pack B through the speaker 331a connected to the interface unit 330.

Meanwhile, when the operation state of the battery cell that is a diagnosis target switches from the charge state to the no-load state, if none of the following inequality 1 and equation 1 is satisfied, the control circuit 220 may diagnose that the battery cell exhibits a voltage abnormality. The inequality 1 corresponds to the inequality described above, and the equation 1 corresponds to an additional condition for increasing diagnostic accuracy even if the cell voltage of the battery cell substantially decreases to the stabilization voltage (i.e., open circuit voltage).

<Inequality 1>

$$\text{first cell voltage slope } (r_1) < \text{average slope } (r_{av}) < \text{second cell voltage slope } (r_2)$$

<Equation 1>

$$\text{first cell voltage slope } (r_1) = \text{average slope } (r_{av}) = \text{second cell voltage slope } (r_2)$$

Similarly, when the operation state of the battery cell that is a diagnosis target switches from the discharge state to the no-load state, if none of the following inequality 3 and equation 2 is satisfied, the control circuit 220 may diagnose that the battery cell exhibits a voltage abnormality. The inequality 3 corresponds to the inequality described above, and the equation 2 corresponds to an additional condition for increasing diagnostic accuracy even if the cell voltage of the battery cell substantially increases to the stabilization voltage (i.e., open circuit voltage).

< Inequality 3>

$$\text{first cell voltage slope } (r_1) > \text{average slope } (r_{av}) > \text{second cell voltage slope } (r_2)$$

< Equation 2>

$$\text{first cell voltage slope } (r_1) = \text{average slope } (r_{av}) = \text{second cell voltage slope } (r_2)$$

The control circuit 220 may periodically execute the diagnosis logic for detecting the voltage abnormality of the battery cell described above for all battery cells. Also, the control circuit 220 may independently execute the diagnosis logic for each battery cell according to a predetermined order when executing diagnosis logics for all battery cells.

The control circuit 220 may also execute in real time the diagnosis logic for detecting the voltage abnormality of the battery cell described above in association with the measurement of cell voltage before obtaining the time series data for the n number of preset cell voltages.

Specifically, referring to FIG. 2a, when the diagnosis of the voltage abnormality for a battery cell begins, the control circuit 220 may execute the first diagnosis cycle when the measurement time point $t_{2+p+1}$ of the cell voltage is passed.

In other words, the control circuit 220 may determine the first cell voltage slope $(r_1)$ in the first time section T1, the second cell voltage slope $(r_2)$ in the second time section T2, and the average slope $(r_{av})$ of the cell voltage in the third time section T3 by using the time series data for the cell voltage measured at the measurement time points $t_1$ to $t_{2+p+1}$.

In addition, referring to FIG. 2b, the control circuit 220 may execute the second diagnosis cycle when the measurement time point $t_{2+p+2}$ of the cell voltage is passed.

In other words, the control circuit 220 may determine the first cell voltage slope $(r_1)$ in the first time section T1, the second cell voltage slope $(r_2)$ in the second time section T2, and the average slope $(r_{av})$ of the cell voltage in the third time section T3 by using the time series data for the cell voltage measured at the measurement time points $t_2$ to $t_{2+p+2}$.

In addition, referring to FIG. 2c, the control circuit 220 may execute an arbitrary $m^{th}$ diagnosis cycle when the measurement time point $t_{m+1+p+1}$ of the cell voltage is passed.

That is, the control circuit 220 may determine the first cell voltage slope $(r_1)$ in the first time section T1, the second cell voltage slope $(r_2)$ in the second time section T2, and the average slope $(r_{av})$ of the cell voltage in the third time section T3 by using the time series data for the cell voltage measured at the measurement time points $t_m$ to $t_{m+1+p+1}$.

The battery diagnosis apparatus 200 according to an embodiment of the present disclosure may be included in a battery management system 100, a control system of a load device (not shown), or a diagnostic system provided in a maintenance center of the vehicle 1 or the battery pack B.

In the present disclosure, the control circuit 220 may optionally include a processor, an application-specific integrated circuit (ASIC), other chipsets, logic circuits, registers, communication modems, data processing devices, etc. known in the art to execute the various control logics described above.

Also, when the control logics are implemented as software, the control circuit 220 may be replaced with a processor that executes a set of program modules. At this time, the program module may be stored in a memory and executed by the processor. The memory may be provided inside or outside the processor, and may be connected to the processor by various well-known computer components. Also, the memory may be included in the storage medium 221. Also, the memory generically refers to a device that stores information regardless of the type of device, and does not refer to a specific memory device.

In addition, one or more of the various control logics of the control circuit 220 are combined, and the combined control logics may be written in a computer-readable code system and recorded on a computer-readable recording medium. The type of the recording medium is not particularly limited as long as it can be accessed by a processor included in a computer. As an example, the recording medium includes at least one selected from the group including a ROM, a RAM, a register, a CD-ROM, a magnetic tape, a hard disk, a floppy disk, and an optical data recording device. In addition, the code system may be distributed and stored and executed in computers connected through a network. In addition, functional programs, codes and code segments for implementing the combined control logics may be easily inferred by programmers in the art to which the present disclosure belongs.

Hereinafter, a battery diagnosis method using the battery diagnosis apparatus 200 of the present disclosure described above will be described in detail. The battery diagnosis method may be performed by the battery diagnosis apparatus 200 while the vehicle 1 is operating. The operation of the vehicle 1 may include running, temporary stop, or parking. The battery diagnosis method may be performed in the process of diagnosing the battery pack B at a maintenance center of the vehicle 1. The battery diagnosis method may be performed while the vehicle 1 is being charged at a charging station. The operation of the control circuit 220 will be described in more detail in various embodiment(s) of the battery diagnosis method.

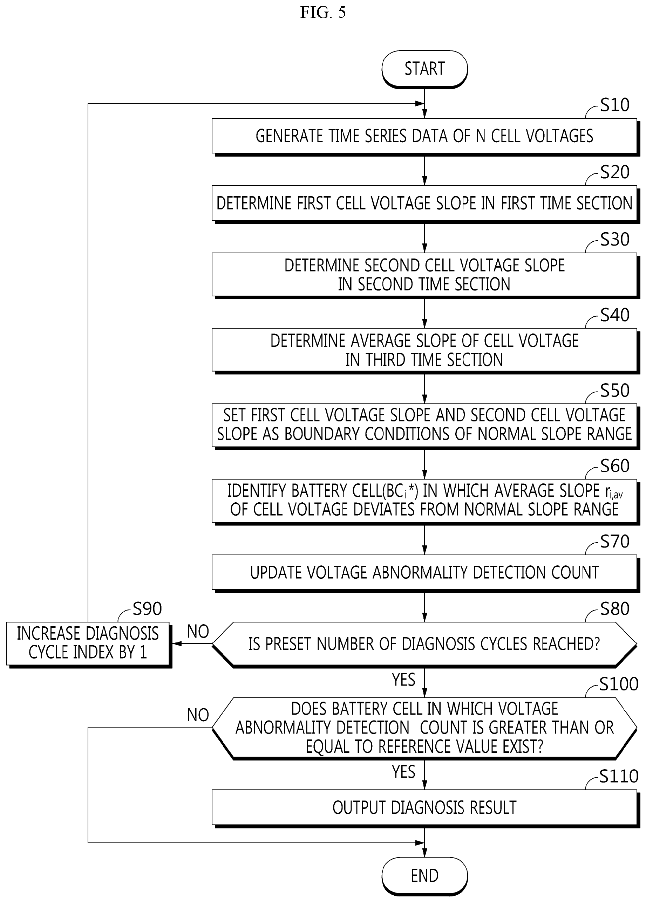

FIG. 5 is a flowchart for exemplarily illustrating a battery diagnosis method according to an embodiment of the present disclosure. The diagnosis method of FIG. 5 may be repeatedly executed at each diagnosis cycle preset by the control circuit 220.

Referring to FIG. 5, when battery diagnosis begins, in the step S10, the control circuit 220 controls the voltage sensing circuit 210 to repeatedly measure the voltage of each battery cell ($BC_i$) at regular time intervals to generate time series data ($V_{i,k}$) for the n number of cell voltages and record it in the storage medium 221. i is an index of the battery cell, and k is a natural number from 1 to n. Accordingly, the time series data ($V_{i,k}$) of the cell voltage for each battery cell ($BC_i$) is recorded and maintained in the storage medium 221. The number of cell voltages that constitute the time series data ($V_{i,k}$) is n.

Subsequently, the control circuit 220 repeats the steps S20 to S90 a preset number of times to determine the voltage abnormality detection count for each battery cell ($BC_i$).

First, in the step S20, the control circuit 220 determines the first cell voltage slope ($r_{i,1}$) in the first time section ($t_1$ to $t_2$) based on the time series data ($V_{i,k}$) for the cell voltage of each battery cell ($BC_i$). The first cell voltage slope ($r_{i,1}$) for each battery cell ($BC_i$) is recorded in the storage medium 221.

Subsequently, in the step S30, the control circuit 220 determines the second cell voltage slope ($r_{i,2}$) in the second time section ($t_{2+p}$ to $t_{2+p+1}$) based on the time series data ($V_{i,k}$) for the cell voltage of each battery cell ($BC_i$). As shown in FIG. 2a, the second time section is spaced apart by $p*\triangle t$ based on the first time section. The second cell voltage slope ($r_{i,2}$) for each battery cell ($BC_i$) is recorded in the storage medium 221.

Subsequently, in the step S40, the control circuit 220 determines the average slope ($r_{i,av}$) of the cell voltage in the third time section ($t_2$ to $t_{2+p}$) between the first time section ($t_1$ to $t_2$) and the second time section ($t_{2+p}$ to $t_{2+p+1}$) based on the time series data ($V_{i,k}$) for the cell voltage of each battery cell ($BC_i$). The average slope ($r_{i,av}$) of the cell voltage for each battery cell ($BC_i$) is recorded in the storage medium 221.

Subsequently, in the step S50, the control circuit 220 sets the first cell voltage slope ($r_{i,1}$) and the second cell voltage slope ($r_{i,2}$) determined for each battery cell ($BC_i$) as boundary conditions of the normal slope range ($Range_i$).

Subsequently, in the step S60, the control circuit 220 identifies a battery cell ($BC_i^*$) as exhibiting a voltage abnormality in response to the average slope ($r_{i,av}$) of the cell voltage determined for each battery cell ($BC_i$) deviating from the normal slope range ($Range_i$) of the corresponding battery cell ($BC_i$). Here, the symbol * indicates a battery cell exhibiting a voltage abnormality. In the step S60, examples of distinguishing a battery cell ($BC_i^*$) exhibiting a voltage abnormality are described above in detail based on the inequalities 1 to 4 and the equations 1 to 2.

Subsequently, in the step S70, the control circuit 220 accumulatively stores the voltage abnormality detection time points for each battery cell ($BC_i^*$) for which a voltage abnormality is detected in the storage medium 221 and increases the voltage abnormality detection count for the corresponding battery cell ($BC_i^*$) by 1. Here, the symbol * is a symbol representing the battery cell in which a voltage abnormality is detected.

Subsequently, in the step S80, the control circuit 220 determines whether the current diagnosis cycle reaches a preset number of diagnosis cycles. When the number of cell voltages included in the time series data ($V_{i,k}$) of the cell voltage is n and the first time section and the second time section are spaced apart by $p*\triangle t$, the preset diagnosis cycle number is 'n-p-2'.

If the determination in the step S80 is NO, the control circuit 220 controls the process to proceed to the step S90. In the step S90, the control circuit 220 increases the diagnosis cycle index by 1 and returns the process back to the step S10. Accordingly, the steps S10 to S80 are repeated as the next diagnosis cycle progresses.

As shown in FIG. 2b, in the second diagnosis cycle, the first time section T1 is changed to $t_2$ to $t_3$, the second time section T2 is changed to $t_{2+p+1}$ to $t_{2+p+2}$, and the third time section T3 is changed to $t_3$ to $t_{2+p+1}$.

As shown in FIG. 2c, in any $m^{th}$ diagnosis cycle, the first time section T1 is changed to $t_m$ to $t_{m+1}$, the second time section T2 is changed to $t_{m+1+p}$ to $t_{m+1+p+1}$, and the third time section T3 is changed to $t_{m+1}$ to $t_{m+1+p}$.

Repetition of the steps S10 to S70 may continue until the determination of the step S80 becomes YES.

If the diagnosis cycle is repeated a preset number of times, the process of distinguishing a battery cell exhibiting a voltage abnormality by comparing the value assigned to the voltage abnormality detection count for each battery cell ($BC_i$) with a reference value and outputting the diagnosis result is performed.

Specifically, in the step S100, the control circuit 220 determines whether there is a battery cell ($BC_i^{\#}$) in which the voltage abnormality detection count assigned to each battery cell ($BC_i$) is greater than or equal to the reference value. Here, the symbol # represents a battery cell in which the voltage abnormality detection count is greater than or equal to the reference value.

If the determination of the step S100 is YES, in the step S110, the control circuit 220 outputs the diagnosis result visually or audibly through the output device 331 connected to the interface unit 330. The diagnosis result may include a warning message indicating that a battery cell exhibiting a voltage abnormality occurs within the battery pack B.

In one example, the control circuit 220 may visually output the diagnosis result through the display 331a. In another example, the control circuit 220 may output the diagnosis result audibly through the speaker 331b.

When the diagnosis result is output, the user of the vehicle 1 may diagnose the state of the battery pack B more precisely by bringing the vehicle 1 to a service center. If phenomena such as lithium plating are actually confirmed in some of the battery cells included in the battery pack B, the battery pack B may be replaced.

Meanwhile, the control circuit 220 may transmit the diagnosis result to an external device through the interface unit 330. The external device may be an on-board vehicle diagnostic device or an off-board vehicle diagnostic device operably coupled through the vehicle controller 5 of the vehicle 1 or the interface unit 330.

Meanwhile, the battery diagnosis method according to the present disclosure may be modified as follows. In other words, the control circuit 220 may execute the diagnosis cycle in real time in association with the measurement of cell voltage before obtaining time series data for the n number of preset cell voltages.

Specifically, the control circuit 220 may execute the first diagnosis cycle when the measurement time point $t_{2+p+1}$ is passed after starting to measure the cell voltage of each battery cell.

That is, referring to FIG. 2a, the control circuit 220 may perform the steps S10 to S70 using the time series data ($V_{i,k}$) of the cell voltage for each battery cell ($BC_i$) measured at the measurement time points $t_1$ to $t_{2+p+1}$ when the measurement time point $t_{2+p+1}$ is passed.

In addition, referring to FIG. 2b, the control circuit 220 may perform the second diagnosis cycle when the measurement time point $t_{2+p+2}$ of the cell voltage is passed. That is, the control circuit 220 may perform the steps S10 to S70 using the time series data ($V_{i,k}$) of the cell voltage for each battery cell ($BC_i$) measured at the measurement time points $t_2$ to $t_{2+p+2}$ when the measurement time point $t_{2+p+2}$ is passed.

In addition, referring to FIG. 2c, the control circuit 220 may perform an arbitrary $m^{th}$ diagnosis cycle when the measurement time point $t_{m+1+p+1}$ of the cell voltage is passed. That is, the control circuit 220 may perform the steps S10 to S70 using the time series data ($V_{i,k}$) of the cell voltage for each battery cell ($BC_i$) measured at the measurement time points $t_m$ to $t_{m+1+p+1}$ when the measurement time point $t_{m+1+p+1}$ is passed.

The execution of the steps S10 to S70 as above may be repeated until the number of diagnosis cycles reaches a preset number. Also, after the execution of the steps S10 to S70 is repeated a preset number of times, the steps S100 and S110 may be executed substantially in the same way as the former embodiment.

According to the above embodiments, a battery cell exhibiting a voltage abnormality may be identified through simple calculation using the slope of the cell voltage calculated in the first time section and the second time section and the average slope of the cell voltage determined between the first time section and the second time section.

According to another embodiment of the present disclosure, since the calculation method used for battery diagnosis is not complicated, a processor with high specification is not required.

According to still another embodiment of the present disclosure, a battery cell that exhibit abnormal voltage behavior may be reliably identified even if the difference between voltages measured at different time points is not large.

In describing various embodiments of the present disclosure, elements named '... unit' or '... circuit' should be understood as functionally distinct elements rather than physically distinct elements. Thus, each component may be selectively integrated with other components or each component may be divided into sub-components for efficient execution of control logic(s). However, it is obvious to those skilled in the art that even if the components are integrated or divided, if the same function can be recognized, the integrated or divided components should also be interpreted as falling within the scope of the present disclosure.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, as many substitutions, modifications and changes may be made to the present disclosure described hereinabove by those skilled in the art without departing from the technical aspects of the present disclosure, the present disclosure is not limited by the above-described embodiments and the accompanying drawings, and all or some of the embodiments may be selectively combined to allow various modifications.

Preferred examples of the Invention are specified in the following items:

Item 1. A battery diagnosis apparatus, comprising:

a voltage sensing circuit configured to generate a voltage signal indicating a cell voltage of a battery cell;
a storage medium configured to store time series data for the cell voltage; and
a control circuit operably coupled with the voltage sensing circuit and the storage medium,
wherein the control circuit is configured to:

(i) receive the voltage signal and record the time series data for the cell voltage in the storage medium,
(ii) determine a first cell voltage slope in a first time section and a second cell voltage slope in a second time section different from the first time section based on the time series data,
(iii) determine an average slope of the cell voltage in a third time section between the first time section and the second time section based on the time series data, and
(iv) set the first cell voltage slope and the second cell voltage slope as boundary conditions of a normal slope range, and diagnose a voltage abnormality in the battery cell in response to the average slope of the cell voltage being outside the normal slope range.

Item 2. The battery diagnosis apparatus according to Item 1,
wherein a time width of the third time section is greater than a time width of the first time section and a time width of the second time section.

Item 3. The battery diagnosis apparatus according to Item 2,
wherein the time width of the first time section and the time width of the second time section are substantially the same.

Item 4. The battery diagnosis apparatus according to Item 1,
wherein the control circuit is configured to:
diagnose the voltage abnormality in response to the first cell voltage slope, the second cell voltage slope, and the average slope of the cell voltage not satisfying the following inequality, for cell voltages in the time series data to show a pattern of substantially continuously decreasing:

$$\text{first cell voltage slope} < \text{average slope of the cell voltage} < \text{second cell voltage slope.}$$

Item 5. The battery diagnosis apparatus according to Item 1,
wherein the control circuit is configured to:
diagnose the voltage abnormality in response to the first cell voltage slope, the second cell voltage slope, and the average slope of the cell voltage not satisfying the following inequality, for cell voltages in the time series data to show a pattern of substantially continuously increasing:

$$\text{first cell voltage slope} > \text{average slope of the cell voltage} > \text{second cell voltage slope.}$$

Item 6. The battery diagnosis apparatus according to Item 1,
wherein the control circuit is configured to:
diagnose the voltage abnormality in response to neither of the following inequality and equation being satisfied, for a battery cell having an operation state that switches from a charge state to a no-load state:

$$\text{first cell voltage slope} < \text{average slope} < \text{second cell voltage slope}$$

$$\text{first cell voltage slope} = \text{average slope} = \text{second cell voltage slope.}$$

Item 7. The battery diagnosis apparatus according to Item 1,
wherein the control circuit is configured to:

diagnose the voltage abnormality in response to neither of the following inequality and equation being satisfied, for a battery cell having an operation state that switches from a discharge state to a no-load state:

$$\text{first cell voltage slope} > \text{average slope} > \text{second cell voltage slope}$$

$$\text{first cell voltage slope} = \text{average slope} = \text{second cell voltage slope}.$$

Item 8. The battery diagnosis apparatus according to Item 1,
wherein the control circuit is configured to update a voltage abnormality detection count in response to diagnosis of the voltage abnormality.

Item 9. The battery diagnosis apparatus according to Item 8, further comprising:

a display operably coupled with the control circuit,
wherein the control circuit is configured to output the result of diagnosing a battery cell satisfying a condition that the voltage abnormality detection count is greater than or equal to a reference value as a battery cell exhibiting a voltage abnormality through the display.

Item 10. The battery diagnosis apparatus according to Item 8, further comprising:

an interface unit operably coupled with the control circuit to support communication with an external device,
wherein the control circuit is configured to transmit the result of diagnosing a battery cell satisfying a condition that the voltage abnormality detection count is greater than or equal to a reference value as a battery cell exhibiting a voltage abnormality to an external device through the interface unit.

Item 11. A battery pack, comprising the battery diagnosis apparatus according to any one of Items 1 to 10.

Item 12. A vehicle, comprising the battery pack according to Item 11.

Item 13. A battery diagnosis method, comprising:

a first step of receiving a voltage signal indicating a cell voltage of a battery cell from a voltage sensing circuit and recording time series data for the cell voltage in a storage medium;
a second step of determining a first cell voltage slope in a first time section based on the time series data;
a third step of determining a second cell voltage slope in a second time section, which is later than the first time section, based on the time series data;
a fourth step of determining an average slope of the cell voltage in a third time section between the first time section and the second time section based on the time series data;
a fifth step of setting the first cell voltage slope and the second cell voltage slope as boundary conditions of a normal slope range; and
a sixth step of diagnosing a voltage abnormality in the battery cell in response to the average slope of the cell voltage being outside the normal slope range.

Item 14. The battery diagnosis method according to Item 13,
wherein a time width of the third time section is greater than a time width of the first time section and a time width of the second time section.

Item 15. The battery diagnosis method according to Item 13,
wherein the sixth step is a step of diagnosing the voltage abnormality in response to the first cell voltage slope, the second cell voltage slope, and the average slope of the cell voltage not satisfying the following inequality, for cell voltages in the time series data to show a pattern of substantially continuously decreasing:

$$\text{first cell voltage slope} < \text{average slope of the cell voltage} < \text{second cell voltage slope.}$$

Item 16. The battery diagnosis method according to Item 13,

wherein the sixth step is a step of diagnosing the voltage abnormality in response to the first cell voltage slope, the second cell voltage slope, and the average slope of the cell voltage not satisfying the following inequality, for cell voltages in the time series data to show a pattern of substantially continuously increasing:

$$\text{first cell voltage slope} > \text{average slope of the cell voltage} > \text{second cell voltage slope.}$$

Item 17. The battery diagnosis method according to Item 13,
wherein the sixth step is a step of diagnosing the voltage abnormality in response to neither of the following inequality and equation being satisfied, for a battery having an operation state that switches from a charge state to a no-load state:

$$\text{first cell voltage slope} < \text{average slope} < \text{second cell voltage slope}$$

$$\text{first cell voltage slope} = \text{average slope} = \text{second cell voltage slope.}$$

Item 18. The battery diagnosis method according to Item 13,
wherein the sixth step is a step of diagnosing the voltage abnormality in response to neither of the following inequality and equation being satisfied, for a battery cell having an operation state that switches from a discharge state to a no-load state:

$$\text{first cell voltage slope} > \text{average slope} > \text{second cell voltage slope}$$

$$\text{first cell voltage slope} = \text{average slope} = \text{second cell voltage slope.}$$

Item 19. The battery diagnosis method according to Item 13, further comprising:
updating a voltage abnormality detection count of the battery cell in response to diagnosis of the voltage abnormality in the battery cell.

Item 20. The battery diagnosis method according to Item 19, further comprising:

outputting the result of diagnosing a battery cell satisfying a condition that the voltage abnormality detection count is greater than or equal to a reference value as a battery cell exhibiting a voltage abnormality through a display; or transmitting the result of diagnosing a battery cell satisfying a condition that the voltage abnormality detection count is greater than or equal to a reference value as a battery cell exhibiting a voltage abnormality to an external device.

**Claims**

1. A battery diagnosis apparatus, comprising:

   a storage medium configured to store time series data of a cell voltage of a battery cell; and
   a control circuit operably coupled with the storage medium,
   wherein the control circuit is configured to:

   determine a first cell voltage slope in a first time section based on the time series data,
   determine a second cell voltage slope in a second time section different from the first time section based on the time series data, and
   diagnose an abnormality in the battery cell based on the first cell voltage slope and the second cell voltage slope.

2. The battery diagnosis apparatus according to claim 1,
   wherein the control circuit is configured to determine an average slope of the cell voltage in a third time section based on the time series data, the third time section being different from the first time section and the second time section.

3. The battery diagnosis apparatus according to claim 2,
wherein the control circuit is configured to set the first cell voltage slope and the second cell voltage slope as boundary conditions of a normal slope range.

4. The battery diagnosis apparatus according to claim 3,
wherein the control circuit is configured to diagnose the abnormality in the battery cell in response to the average slope of the cell voltage being outside the normal slope range.

5. The battery diagnosis apparatus according to claim 2,
wherein the control circuit is configured to execute at least one of:

an operation of diagnosing the abnormality in the battery cell in response to the first cell voltage slope, the second cell voltage slope, and the average slope of the cell voltage not satisfying the following inequality, for cell voltages in the time series data to show a pattern of continuously decreasing:

$$\text{first cell voltage slope} < \text{average slope of the cell voltage} < \text{second cell voltage slope},$$

or
an operation of diagnosing the abnormality in the battery cell in response to the first cell voltage slope, the second cell voltage slope, and the average slope of the cell voltage not satisfying the following inequality, for cell voltages in the time series data to show a pattern of continuously increasing:

$$\text{first cell voltage slope} > \text{average slope of the cell voltage} > \text{second cell voltage slope}.$$

6. The battery diagnosis apparatus according to claim 2,
wherein the control circuit is configured to execute at least one of:

an operation of diagnosing the abnormality in the battery cell in response to neither of the following inequality and equation being satisfied, for a battery cell having an operation state that switches from a charge state to a no-load state:

$$\text{first cell voltage slope} < \text{average slope} < \text{second cell voltage slope}$$

$$\text{first cell voltage slope} = \text{average slope} = \text{second cell voltage slope, and}$$

an operation of diagnosing the abnormality in the battery cell in response to neither of the following inequality and equation being satisfied, for a battery cell having an operation state that switches from a discharge state to a no-load state:

$$\text{first cell voltage slope} > \text{average slope} > \text{second cell voltage slope}$$

$$\text{first cell voltage slope} = \text{average slope} = \text{second cell voltage slope}.$$

7. A battery pack, comprising the battery diagnosis apparatus according to any one of claims 1 to 6.

8. A vehicle, comprising the battery pack according to claim 7.

9. A battery diagnosis method, comprising:

determining a first cell voltage slope in a first time section based on time series data of a cell voltage of a battery cell;
determining a second cell voltage slope in a second time section different from than the first time section based on the time series data; and
diagnosing an abnormality in the battery cell based on the first cell voltage slope and the second cell voltage slope.

10. The battery diagnosis method according to claim 9, after the step of determining a second cell voltage slope, further comprising:
determining an average slope of the cell voltage in a third time section based on the time series data, the third time section being different from the first time section and the second time section.

11. The battery diagnosis method according to claim 10, after the step of determining an average slope, further comprising:
setting the first cell voltage slope and the second cell voltage slope as boundary conditions of a normal slope range.

12. The battery diagnosis method according to claim 11,
wherein the step of diagnosing an abnormality in the battery cell is a step of diagnosing the abnormality in the battery cell in response to the average slope of the cell voltage being outside the normal slope range.

13. The battery diagnosis method according to claim 10,
wherein the step of diagnosing an abnormality in the battery cell includes at least one of:

diagnosing the abnormality in the battery cell in response to the first cell voltage slope, the second cell voltage slope, and the average slope of the cell voltage not satisfying the following inequality, for cell voltages in the time series data to show a pattern of continuously decreasing:

$$\text{first cell voltage slope} < \text{average slope of the cell voltage} < \text{second cell voltage slope},$$

and
diagnosing the abnormality in the battery cell in response to the first cell voltage slope, the second cell voltage slope, and the average slope of the cell voltage not satisfying the following inequality, for cell voltages in the time series data to show a pattern of continuously increasing:

$$\text{first cell voltage slope} > \text{average slope of the cell voltage} > \text{second cell voltage slope}.$$

14. The battery diagnosis method according to claim 10,
wherein the step of diagnosing an abnormality in the battery cell includes at least one of:

diagnosing the abnormality in the battery cell in response to neither of the following inequality and equation being satisfied, for a battery having an operation state that switches from a charge state to a no-load state:

$$\text{first cell voltage slope} < \text{average slope} < \text{second cell voltage slope}$$

$$\text{first cell voltage slope} = \text{average slope} = \text{second cell voltage slope, and}$$

diagnosing the abnormality in the battery cell in response to neither of the following inequality and equation being satisfied, for a battery cell having an operation state that switches from a discharge state to a no-load state:

$$\text{first cell voltage slope} > \text{average slope} > \text{second cell voltage slope}$$

$$\text{first cell voltage slope} = \text{average slope} = \text{second cell voltage slope}.$$

15. A computer-readable recording medium on which a program for executing the battery diagnosis method according to any one of claims 9 to 14 on a computer is recorded.

FIG. 1

FIG. 2a

**FIRST DIAGNOSIS CYCLE**

FIG. 2b

**SECOND DIAGNOSIS CYCLE**

FIG. 2c

**THIRD DIAGNOSIS CYCLE**

FIG. 3a

FIG. 3b

FIG. 4a

FIG. 4b

FIG. 5

START

S10
GENERATE TIME SERIES DATA OF N CELL VOLTAGES

S20
DETERMINE FIRST CELL VOLTAGE SLOPE IN FIRST TIME SECTION

S30
DETERMINE SECOND CELL VOLTAGE SLOPE
IN SECOND TIME SECTION

S40
DETERMINE AVERAGE SLOPE OF CELL VOLTAGE
IN THIRD TIME SECTION

S50
SET FIRST CELL VOLTAGE SLOPE AND SECOND CELL VOLTAGE
SLOPE AS BOUNDARY CONDITIONS OF NORMAL SLOPE RANGE

S60
IDENTIFY BATTERY CELL($BC_i$*) IN WHICH AVERAGE SLOPE $r_{i,av}$
OF CELL VOLTAGE DEVIATES FROM NORMAL SLOPE RANGE

S70
UPDATE VOLTAGE ABNORMALITY DETECTION COUNT

S90
INCREASE DIAGNOSIS
CYCLE INDEX BY 1

NO

S80
IS PRESET NUMBER OF DIAGNOSIS CYCLES REACHED?

YES

S100
DOES BATTERY CELL IN WHICH VOLTAGE
ABNORMALITY DETECTION COUNT IS GREATER THAN OR
EQUAL TO REFERENCE VALUE EXIST?

NO

YES

S110
OUTPUT DIAGNOSIS RESULT

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220117335